Europäisches Patentamt

(19) European Patent Office

Office européen des brevets

(11) Numéro de publication: **0 142 386**
**B1**

(12) **FASCICULE DE BREVET EUROPEEN**

(45) Date de publication du fascicule du brevet: 20.07.88

(21) Numéro de dépôt: 84401702.0

(22) Date de dépôt: 22.08.84

(51) Int. Cl.⁴: **G 03 F 7/02, B 41 N 1/12**

(54) Perfectionnements à la fabrication de clichés en relief en matière photopolymère.

(30) Priorité: 31.08.83 ES 525778
26.06.84 ES 533703

(43) Date de publication de la demande:
22.05.85 Bulletin 85/21

(45) Mention de la délivrance du brevet:
20.07.88 Bulletin 88/29

(84) Etats contractants désignés:
AT BE CH DE FR GB IT LI LU NL SE

(56) Documents cités:
CH-A- 453 897
FR-A-1 222 329
FR-A-2 156 339
FR-A-2 206 867
FR-A-2 214 136
FR-A-2 286 420
FR-A-2 323 169
GB-A- 841 454
US-A-2 381 704
US-A-3 146 106
US-A-3 663 222
US-A-4 115 119

(73) Titulaire: INDAGRAF S.A.
Béjar 74-80
Barcelone (ES)

(72) Inventeur: Almorin Navarrete, Juan
Cisneros, 22
Alcoy (Alicante) (ES)

(74) Mandataire: de Boisse, Louis et al
CABINET DE BOISSE 37, Avenue Franklin D.
Roosevelt
F-75008 Paris (FR)

Courier Press, Leamington Spa, England.

**Description**

La présente invention, concernant la photographie, est plus spécifiquement relative à des perfectionnements introduits dans la fabrication de clichés en relief en matière photopolymère, laquelle offre actuellement, relativement au système classique des avantages multiples, spécialement de genre économique.

On connaît par FR-A-2 286 420, un procédé de fabrication d'une plaque d'impression consistant (a) à superposer en contact intime une couche de résine photosensible à un support qui est au moins semi-transparent à la lumière actinique; (b) à exposer l'ensemble à de la lumière actinique à travers un élément transparent portant une image, du côté de ladite couche de résine photosensible, en face dudit support; et (c) exposer l'ensemble à de la lumière actinique à travers un élément transparent portant une image de points, du côté dudit support pour former ainsi sur ledit support des reliefs comme zones d'images et un certain nombre de petites saillies moins hautes que lesdits reliefs dans les zones en blanc, les étapes (b) et (c) pouvant être effectuées dans un ordre quelconque ou simultanément.

On connaît aussi pour la fabrication de clichés de cette classe, un procédé selon lequel on utilise un photopolymère adéquat, c'est-à-dire une résine gélatineuse sensible à la lumière, et un négatif photographique, qu'on place dans une machine d'exposition et sur lequel on verse ladite résine, le tout étant couvert par une lame transparente de polyester. La lumière ultra-violette projetée, passant par les deux faces, pénètre au travers de la base considérée, et des parties transparentes de ce négatif (lesquelles correspondent aux lettres ou motifs que doit avoir le cliché), et la résine qui a reçu les radiations durcit et dessine les lettres ou motifs mentionnés. Cette opération fait que la base finale est constituée par la feuille de polyester et une couche de résine durcie, à partir de laquelle s'élèvent les reliefs déterminant les lettres ou motifs. La fabrication se termine par un lavage à l'eau et avec un détergent neutre à 40°C pour éliminer les restes de résine gélatineuse; puis on effectue une deuxième exposition aux rayons ultra-violets pour durcir les parois latérales des lettres ou autres. Ensuite on sèche et le cliché est prêt à produire les impressions prévues.

Ce procédé habituel présente l'inconvénient qu'on ne récupère pas la totalité de la résine gélatineuse située entre les parties durcissantes, car une certaine quantité de celle-ci vient former une couche durcie qui détermine, conjointement avec la couche de polyester, la base du cliché.

L'invention concerne un procédé de production de clichés en relief en matière photopolymère comportant les étapes suivantes: (a) on applique une couche de résine photosensible gélatineuse sur un négatif photographique transparent ayant des zones opaques et transparentes définissant le modèle du cliché en relief désiré, (b) on applique sur la surface supérieure de la couche de résine une feuille destinée à servir de support audit cliché, (c) on expose la couche de résine photosensible à un rayonnement ultra-violet à travers le négatif photographique de façon à durcir les zones de la couche de résine photosensible se trouvant derrière les zones transparentes du négatif, (d) on retire le négatif photographique, (e) on élimine les zones non durcies de la couche de résine photosensible, caractérisé en ce que la résine photosensible appliquée est gélatineuse et en ce qu'on utilise comme feuille destinée à servir de support une feuille flexible et opaque, cette feuille présentant une face rugueuse sur celui de ses côtés qui est appliqué contre la couche de résine et en ce qu'on expose de nouveau les zones durcies de la résine subsistantes à un rayonnement ultra-violet pour durcir leurs parois latérales.

Grâce aux perfectionnements de la présente demande, on économise 60% de la résine par rapport au système normal, ce qui s'obtient sans employer la feuille transparente de polyester et en utilisant en échange un voile opaque et rugueux, normalement en toile sur caoutchouc, sur lequel durcissent les parties de la résine affectées par les rayons, tandis qu'aux endroits situés en dessous des zones opaques du négatif la matière reste totalement gélatineuse et peut être récupérée, sans qu'il se forme aucune couche de cette même résine comme composant de la base du cliché. Dans ce cas, seule se durcit la résine correspondant aux lettres ou motifs, lesquels font directement saillie à partir de la surface de la toile ou surface rugueuse semblable.

A part cela, on obtient une adhérence parfaite entre les contours ou corps imprimants du cliché et leur support flexible, ce qui garantit une grande résistance pour éviter tout détachement pendant l'emploi dudit cliché.

Le présent procédé est remarquable par le fait qu'on utilise, comme support desdits reliefs, une plaque flexible complètement opaque, présentant une surface rugueuse qui assure l'adhérence et la fixation sur celle-ci des reliefs mentionnés, support qui est constitué de préférence par dé la toile superposée à du caoutchouc; qu'on dirige dans ce cas uniquement les rayons ultra-violets durcisseurs mentionnés sur la face de l'ensemble opposée à celle formée par un tel support, c'est-à-dire sur celle que présente le négatif photographique, ce qui fait que la résine contenue entre les zones non transparentes de celui-ci, la base de toile et caoutchouc et les lettres ou motifs, est protégée contre l'action des rayons et reste par conséquent en totalité à l'état gélatineux, et que grâce à cela elle peut être complètement récupérée pour des usages ultérieurs.

Les reliefs définitifs qu'on obtient normalement au travers des zones libres transparentes irradiées du négatif photographique, présentent dans ce cas la constitution finale d'appliques directes adhérant à la surface rugueuse qui les supporte, à la surface de laquelle (toujours de nature différente de celle de la résine utilisée) le résidu gélatineux a été complètement éliminé après durcissement des parties traitées par les rayons et, avant de procéder au lavage, à l'exposition ultérieure, durcissante et complémentaire, des parois latérales des reliefs jusqu'à la toile, et au séchage de l'ensemble.

Conformément à une variante améliorée des perfectionnements cités, on prépare des clichés de type composite ou simple; dans le premier cas, lorsque les contours imprimants du clichés possèdent une section suffisante pour avoir une bonne adhérence individuelle à leur support flexible commun, le cliché est formé en employant, pour ledit support, au moins deux couches superposées de matériau et constitution différents, qui sont liées entre elles et qui sont opaques, l'une intérieure de genre textile (couche poreuse) et l'autre extérieure de nature compacte, telle que du caoutchouc, une matière plastique ou semblable, ladite couche intérieure poreuse étant celle qui reste directement fixée aux contours individuels mentionnés, une fois que la résine photosensible qui les constitue s'est durcie sous l'effet des rayons ultra-violets appliqués sur la face occupée par le négatif initial.

Lorsque les contours imprimants mentionnés ont une section réduite, leur adhérence à la couche textile les supportant est assurée au moyen d'une couche mince de résine photosensible qu'on laisse au fond, dans les intervalles, entre contours, cette couche se durcissant conjointement avec de tels contours sans augmenter de façon appréciable l'épaisseur du support en question ni affecter sa souplesse.

Les clichés de type simple se préparent en formant leur support flexible à partir d'une seule couche de matériau compact ou poreux, de nature opaque, telle que du caoutchouc, un tissu, une matière plastique ou analogue, couche sur la face intérieure de laquelle les reliefs mentionnés sont durcis directement et avec leur forme individuelle.

Lorsque les contours imprimants devant être durcis sous la couche unique de support flexible ont une petite section, leur adhérence à celle-ci est assurée au moyen de la couche mince mentionnée de résine photosensible entre les contours qui se consolide avec ceux-ci par l'effet de l'irradiation.

En vue d'une meilleure compréhension de la présente description il est annexé une planche de dessins sur laquelle, seulement à titre d'exemple et non limitativement, on a schématiquement représenté les phases fondamentales selon les susdits perfectionnements, ainsi que les clichés obtenus avec eux. Sur ces dessins:

— la figure 1 montre la phase de préparation du cliché, avant le durcissement de la résine photosensible;

— la figure 2 correspond à la phase d'application des rayons durcisseurs;

— la figure 3 représente le cliché terminé;

— la figure 4 est la vue schématique de la phase de fabrication d'un cliché de type composite;

— la figure 5 montre ledit cliché terminé;

— la figure 6 montre la phase de préparation d'un cliché de type simple;

— la figure 7 représente le cliché terminé;

— les figures 8 et 9 montrent d'autres clichés assez semblables à ceux des figures précédentes, mais préparées pour avoir des corps imprimants ou reliefs de petite section, c'est-à-dire des reliefs fins.

Conformément à la présente demande on procède comme suit:

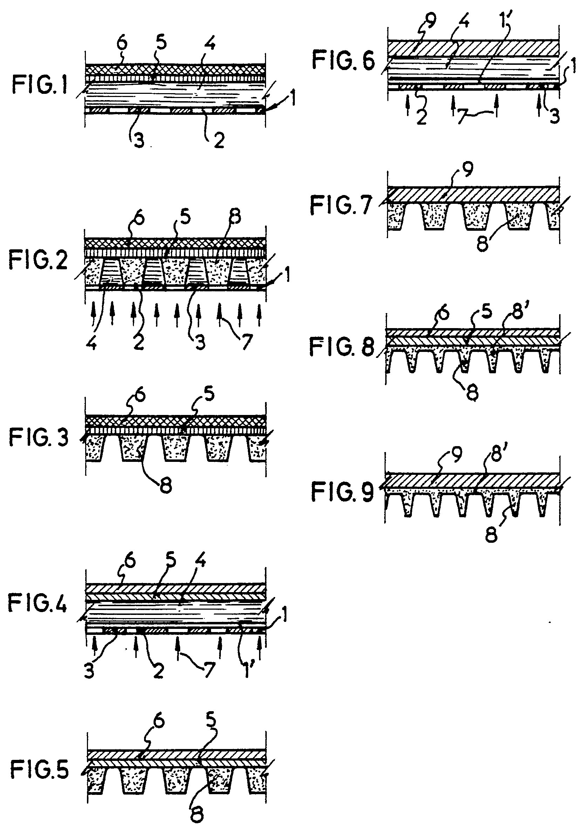

On prépare (figure 1) le négatif photographique convenable 1 comportant des zones transparentes 2 et opaques 3, les premières correspondant aux lettres, motifs et autres qui devront apparaître dans le cliché final.

Sur ledit négatif 1 on verse ou étend la résine gélatineuse 4 et ensuite on applique sur elle un voile opaque formé par une toile 5 adhérant à une couche extérieure de caoutchouc 6.

Puis (figure 2) on soumet l'ensemble à l'action unilatérale de rayons ultra-violets 7, qui sont appliqués seulement par la face occupée par le cliché 1 et atteignent la résine 4 située devant les zones transparentes 2 du négatif 1 et la durcissent, en convertissant ladite résine en corps ou contours en relief 8 adhérant fortement à la toile 5 et correspondant exactement à la forme des lettres ou motifs. La résine gélatineuse restante 4 (figure 3), soit celle enfermée entre lesdits reliefs 8, les zones opaques 3 du cliché 1 et la surface 5, c'est-à-dire celle qui n'a pas été affectée par la lumière due à ces parties 3, peut être récupérée en totalité, car il ne se forme aucune couche de cette résine sur la surface de la toile 5. Les reliefs 8 seront parfaitement définis sur leur support ou base 5 ou 6.

De la phase mentionnée, dans laquelle, comme il a été indiqué, on a récupéré la résine à l'état gélatineux, on passe aux phases normales de lavage (pour éliminer les restes d'une telle résine qui auraient pu subsister), à la deuxième exposition aux mêmes rayons (pour durcir les parois latérales des reliefs 6) et au séchage final de l'ensemble par de l'air chaud, phases qui n'ont pas été représentées parce qu'elles sont usuelles.

L'épaisseur de la base en toile/caoutchouc 5-6 est très variable, selon le modèle de machine imprimante qui doit utiliser le cliché.

Il est évident que le résultat obtenu conformément aux perfectionnements ici expliqués diffère de celui obtenu par le procédé classique par le fait que la base d'où s'élèvent les reliefs ou contours (lettres ou motifs) est maintenant opaque (toile et caoutchouc) et que celle-ci ne comporte aucune couche de résine photopolymère, contrairement à ce qui se passe avec le support ou base habituel de polyester et résine du type considéré. La quantité de résine photosensible récupérée est alors très supérieure à celle obtenue par le système normal, car conformément à l'invention elle n'est pas durcie par la lumière ultra-violette qui rencontre de tous côtés une protection vis-à-vis de la lumière.

On doit signaler que la base de toile et caoutchouc pourrait être remplacée par toute autre combinaison opaque et flexible, pourvu que celle-ci possède une surface rugueuse pour permettre l'adhérence de la résine.

Dans les variantes de réalisation qui apparaissent sur les figures 4 à 7, on a encore amélioré les perfectionnements exposés jusqu'à présent.

Selon les figures 4 et 5, on prépare le cliché en partant du négatif habituel 1, pourvu d'une pellicule transparente protectrice 1' et des zones convenables transparentes 2 et opaques 3. On applique sur ce négatif la résine photosensible 4, qu'on couvre d'une base souple formée, dans le cas présent, par au moins deux couches de nature distincte, l'une intérieure textile 5 (couche poreuse) et l'autre extérieure en matière compacte 6, telle que du caoutchouc, une matière plastique ou semblable. Ces deux couches 5 et 6 sont opaques.

Quand on procède à l'irradiation de l'ensemble par la face occupée par le négatif 1, les rayons ultra-violets 7 causent la consolidation ou le durcissement indiqué de la résine photosensible 4, qui se convertit en corps imprimants 8 (reliefs), en correspondance avec les zones transparentes 2 du négatif 1, tandis que la résine résiduelle non irradiée sera récupérée pour usage ultérieur comme déjà dit. Ces reliefs 8 restent fortement adhérents à la couche textile 5, quel que soit son degré de porosité ou de compacité. Quant à la fixation mutuelle entre les couches 5 et 6, c'est la résine 4 elle-même qui assure, en se solidifiant, une telle liaison par traversée de la couche poreuse 5, en arrivant jusqu'à la couche compacte extérieure 6.

Dans la variante des figures 6 et 7, la base du cliché se prépare en employant une seule couche flexible opaque 9 d'une matière quelconque, compacte ou poreuse, pouvant être du caoutchouc, un tissu, une matière plastique ou autre; sur la face interne de cette couche 9 se forment et se fixent, par l'action des rayons 7 sur la résine photosensible, les reliefs 8 en question comme dans l'exemple précédent. Comme on peut le voir, il n'existe pas, dans ce mode de réalisation, de couche intermédiaire poreuse 5 et les reliefs mentionnés sont directement appliqués sur la base simple 9.

On doit signaler que dans le cas des figures 4 et 5 la couche poreuse 5 ne se limite pas au tissu de la toile de la réalisation principale; maintenant on peut utiliser les tissus les plus divers. Pour la couche extérieure 6 on peut utiliser diverses autres matières en dehors du caoutchouc original.

En ce qui concerne la réalisation des figures 6 et 7, la gamme des matières aptes à fournir la couche unique 9 est très ample, ainsi qu'il a été antérieurement expliqué. Que ce soit suivant un mode de réalisation ou un autre, la flexibilité du cliché est complète, ce qui permet de le monter parfaitement bien dans les tambours d'impression.

Avec les clichés des figures 3, 5 et 7, la base des corps ou reliefs imprimants normaux 8 est suffisamment ample pour permettre leur bonne adhérence à la couche 5 ou 9, mais quand de tels reliefs doivent être fins, c'est-à-dire de section réduite, il est alors nécessaire de renforcer l'adhérence mentionnée, en recourant aux solutions des figures 8 et 9.

Si l'épaisseur et la flexibilité du support du cliché le permettent, on laisse dans les intervalles entre les reliefs 8 une fine couche de résine 8', laquelle assure la liaison sans augmenter sensiblement l'épaisseur ni réduire la souplesse du cliché lui-même. Cette couche auxiliaire ou de fond 8' s'emploie aussi bien dans le cas où le cliché est de type composite (figure 8) ou formé par les couches 5 et 6, que dans celui d'un type simple (figure 9) déterminé par la couche unique 9.

Dans les modes de réalisation des figures 8 et 9, on comprend qu'on peut utiliser le négatif 1 ainsi que son protecteur 1' avec la même forme et la même fonction, comme exposé.

Comme on peut le voir, dans tous les cas on résout le problème d'une parfaite adhérence entre la résine photosensible et son support, aussi bien pour des reliefs imprimants normaux ou de base ample que pour des reliefs fins ou à point de contact réduit, tout ceci sans devoir augmenter l'épaisseur totale du support du cliché ni affecter la souplesse nécessaire de ce dernier.

**Revendications**

1. Procédé de production de clichés en relief en matière phototopolymère comportant les étapes suivantes: (a) on applique une couche de résine photosensible gélatineuse sur un négatif photographiqe transparent ayant des zones opaques et transparentes définissant le modèle du cliché en relief désiré, (b) on applique sur la surface supérieure de la couche de résine une feuille destinée à servir de support audit cliché, (c) on expose la couche de résine photosensible à un rayonnement ultra-violet à travers le négatif photographique de façon à durcir les zones de la couche de résine photosensible se trouvant derrière les zones transparentes du négatif, (d) on retire le négatif photographique, (e) on élimine les zones non durcies de la couche de résine photosensible, caractérisé en ce que la résine photosensible appliquée est gélatineuse, et en ce qu'on utilise comme feuille destinée à servir de support une feuille flexible et opaque, cette feuille présentant une face rugueuse sur celui de ses côtés qui est appliqué contre la couche de résine et en ce qu'on expose de nouveau les zones durcies de la résine subsistantes à un rayonnement ultraviolet pour durcir leurs parois latérales.

2. Procédé selon la revendication 1, caractérisé en ce que la feuille flexible opaque comprend une première feuille formée d'une matière compacte, telle que du caoutchouc ou une matière plastique, et une deuxième feuille poreuse et rugueuse, telle qu'une matière textile, liée à la première feuille.

3. Procédé selon l'une quelconque des revendications 1 à 2, caractérisé en ce qu'on dispose une feuille protectrice transparente sur le négatif transparent avant d'y appliquer la résine photosensible.

4. Procédé selon l'une quelconque des revendications 1 à 3, caractérisé en ce que, dans l'étape (e), on n'élimine que partiellement la résine photosensible dans les zones non durcies en laissant subsister, au contact de la feuille flexible opaque, une mince couche de résine photosensible reliant les zones durcies.

## Patentansprüche

1. Verfahren zum Herstellen von Reliefdruckplatten aus einem Photopolymer, das die folgenden Schritte aufweist: (a) eine gelatineartige photosensible Kunstharzschicht wird auf ein lichtdurchlässiges photographisches Negativ aufgebracht, das lichtundurchlässige und lichtdurchlässige Bereiche besitzt und das Modell der Druckplatte mit dem gewünschten Relief bildet, (b) auf die Oberfläche der Kunstharzschicht wird ein Blatt aufgebracht, das als Träger für die Druckplatte dienen soll, (c) die photosensible Kunstharzschicht wird einer ultravioletten Strahlung durch das photographische Negativ hindurch ausgesetzt, so daß die sich hinter den lichtdurchlässigen Bereichen des Negativs befindenden Bereiche der photosensiblen Kunstharzschicht härten, (d) das photographische Negativ wird zurückgezogen, (e) die nicht gehärteten Bereiche der photosensiblen Kunstharzschicht werden eliminiert, dadurch gekennzeichnet, daß das aufgebrachte photosensible Kunstharz gelatineartig ist und daß als Blatt, das als Träger dienen soll, ein flexibles und lichtundurchlässiges Blatt verwendet wird, wobei dieses Blatt eine rauhe Fläche auf derjenigen ihrer Seiten aufweist, die an der Kunstharzschicht anliegt, und daß die verbleibenden gehärteten Bereiche des Kunstharzes erneut einer ultravioletten Strahlung ausgesetzt werden, um ihre seitlichen Wände zu härten.

2. Verfahren nach Anspruch 1, dadurch gekennzeichnet, daß das lichtundurchlässige flexible Blatte gebildet wird von einem ersten Blatt, das aus einer kompakten Materie wie Kautschuk oder Kunststoff besteht, und einem porösen und rauhen zweiten Blatt wie zB einem textilen Gebilde, das mit dem ersten Blatt verbunden ist.

3. Verfahren nach einem der Ansprüche 1 und 2, dadurch gekennzeichnet, daß ein transparentes Schutzblatt auf dem lichtdurchlässigen Negativ angeordnet wird, bevor das photosensible Kunstharz auf diesem aufgebracht wird.

4. Verfahren nach einem der Ansprüche 1-3, dadurch gekennzeichnet, daß bei dem Schritt (e) nur teilweise das photosensible Kunstharz in den nicht gehärteten Bereichen eliminiert wird, während eine dünne Schicht aus photosensiblem Kunstharz, die die gehärteten Zonen verbindet, in Berührung mit dem lichtundurchlässigen flexiblen Blatt belassen wird.

## Claims

1. Process for the manufacture of photopolymeric relief printing plates, consisting of the following stages:

(a) A layer of gelatinous photosensitive resin is applied to a transparent photographic negative having opaque zones and transparent zones defining the model of the desired relief printing plate,

(b) A sheet intended to form a support for the said printing plate is applied to the upper surface of the layer of resin,

(c) The layer of photosensitive resin is exposed to an ultra-violet radiation through the photographic negative in such a manner as to harden those zones of the layer of photosensitive resin which are situated behind the transparent zones of the negative,

(d) the photographic negative is removed,

(e) The non-hardened zones of the layer of photosensitive resin are eliminated, characterized by the fact that the photosensitive resin applied is gelatinous and that a flexible and opaque sheet is used as the sheet intended to serve as a support, this sheet having a rough face on the side applied against the layer of resin and that the subsisting hardened zones of the resin are again exposed to an ultra-violet radiation in order to harden their side walls.

2. Process in accordance with Claim 1, characterized by the fact that the opaque flexible sheet comprises a first sheet consisting of a compact material, such as rubber, or a plastic material, and a second sheet, which is porous and rough, such as a textile material, connected to the first sheet.

3. Process in accordance with either of Claims 1 and 2, characterized by the fact that a transparent protective sheet is placed on the transparent negative before the photosensitive resin is applied thereto.

4. Process in accordance with any of Claims 1 to 3, characterized by the fact that in stage (e) the photosensitive resin in the non-hardened zones is only partly eliminated and that a thin layer of photosensitive resin interconnecting the hardened zones is allowed to subsist in contact with the opaque flexible sheet.

FIG.1

FIG.2

FIG.3

FIG.4

FIG.5

FIG.6

FIG.7

FIG.8

FIG.9